# EUROPÄISCHE PATENTSCHRIFT

(11) **EP 0 814 488 B1**
(45) Veröffentlichungstag und Bekanntmachung des Hinweises auf die Patenterteilung: **23.01.2002**
(21) Anmeldenummer: 97107252.5
(22) Anmeldetag: 02.05.1997
(51) Int. Cl.: H01H 1/60, H01C 10/30, G01D 5/165

(54) **Positionssensor**
Position sensor
Capteur de position

(30) Priorität: 21.06.1996 DE 19624780
(43) Veröffentlichungstag der Anmeldung: 29.12.1997
(73) Patentinhaber: ROBERT BOSCH GMBH, 70442 Stuttgart (DE)
(72) Erfinder: Brammer, Hartmut, 71665 Vaihingen (DE); Rehmann, Wolfgang, 71679 Asperg (DE); Klotzbuecher, Thomas, 73635 Rudersberg (DE)

(56) Entgegenhaltungen:
- EP-A- 0 632 253
- US-A- 4 990 272
- ANONYMOUS: "Materials for Sliding Electrical Contacts. July 1980." IBM TECHNICAL DISCLOSURE BULLETIN, Bd. 23, Nr. 2, Juli 1980, NEW YORK, US, Seite 502 XP002040637
- PATENT ABSTRACTS OF JAPAN vol. 013, no. 179 (C-590), 26.April 1989 & JP 01 009297 A (TOKAI RIKA CO LTD), 12.Januar 1989,

## Beschreibung

Die Erfindung geht aus von einem Positionssensor nach der Gattung des Anspruchs 1. Ein solcher Positionssensor ist z. B. in der EP-A-0632253 beschrieben.

Ein Positionssensor umfaßt üblicherweise ein erstes Sensorteil und ein zweites Sensorteil. Der Positionssensor dient zum Erfassen der relativen Position zweier gegeneinander bewegbarer Bauteile. Das erste Sensorteil des Positionssensors ist mit einem der beiden Bauteile bewegungsmäßig gekoppelt und das zweite Sensorteil ist mit dem jeweils anderen Bauteil bewegungsmäßig gekoppelt. Eines der beiden Sensorteile umfaßt mindestens eine Kontaktbahn und das jeweils andere Sensorteil umfaßt mindestens einen die Kontaktbahn elektrisch kontaktierenden Kontakt, wobei bei Bewegung der beiden Bauteile gegeneinander sich die Stellung des Kontakts gegenüber der Kontaktbahn entsprechend verändert.

Eine wichtige Forderung der Benutzer des Positionssensor ist, daß während der gesamten vorgesehenen Benutzungsdauer des Positionssensors der Übergangswiderstand zwischen der Kontaktbahn und dem die Kontaktbahn elektrisch kontaktierenden Kontakt nicht unzulässig ansteigt. Bei der Bewegung der beiden Sensorteile gegeneinander reibt der Kontakt entlang der Kontaktbahn, was zu Veränderungen der Oberfläche der Kontaktbahn an den von dem Kontakt überstrichenen Stellen und zu Veränderungen der Oberfläche des Kontakts an der Berührstelle führen kann. Diese Veränderungen kommen hauptsächlich von dem Abrieb an der Kontaktbahn bzw. am elektrischen Kontakt. Diese Veränderungen, insbesondere der Abrieb, können während der Benutzungsdauer des Positionssensors einen erheblichen Anstieg des Übergangswiderstands zwischen dem elektrischen Kontakt und der Kontaktbahn hervorrufen. Dadurch ist die mögliche Benutzungsdauer des bisher bekannten Positionssensors erheblich eingeschränkt.

Eine weitere wichtige Forderung der Benutzer des Positionssensors ist, daß auch nach längerer Nichtbenutzung des Positionssensors bei seiner Wiederinbetriebnahme keine Funktionsstörungen auftreten. Diese Forderung wurde bisher nicht immer voll zufriedenstellend erfüllt.

### Vorteile der Erfindung

Der erfindungsgemäße Positionssensor mit den kennzeichnenden Merkmalen des Anspruchs 1 hat demgegenüber den Vorteil, daß durch die Schutzschicht auf der vom elektrischen Kontakt kontaktierten Kontaktbahn die mögliche Benutzungsdauer des Positionssensors erheblich verlängert wird, und durch die mindestens teilweise reduzierte Auftragschichtdicke der Schutzschicht an mindestens einer Stelle wird die Funktionssicherheit, insbesondere auch bei tiefen Temperaturen, wesentlich gesteigert.

Durch die in den Unteransprüchen aufgeführten Maßnahmen sind vorteilhafte Weiterbildungen und Verbesserungen des im Hauptanspruch angegebenen Positionssensors möglich.

Wird die Auftragschichtdicke der Schutzschicht an der mindestens einen Stelle auf Null reduziert, mit anderen Worten, wird die Schutzschicht an der mindestens einen Stelle nicht aufgetragen, so ergibt dies vorteilhafterweise eine weitere Steigerung der Funktionssicherheit.

Wird die mindestens eine Stelle, an der die Auftragschichtdicke der Schutzschicht mindestens teilweise -reduziert ist bzw. die Stelle, an der die Schutzschicht nicht aufgetragen ist, an die Stelle gelegt, an der der elektrische Kontakt die Kontaktbahn einige Zeit in Ruhe kontaktiert, so bietet dies erhebliche Vorteile bei der Funktionssicherheit des Positionssensors, weil bei Beginn einer Bewegung des Kontakts gegenüber der Kontaktbahn kein störender, eventuell die elektrische Verbindung zwischen dem Kontakt und der Kontaktbahn unterbrechender Einfluß durch die Schutzschicht zu befürchten ist.

Besteht die Schutzschicht aus einem Fett, einem fettartigen oder einem ölartigen Material, so ist die Schutzwirkung der Schutzschicht vorteilhafterweise besonders groß, ohne daß an den Stellen, an denen die Schutzschicht aufgetragen ist, Störungen bei der elektrischen Verbindung zwischen dem Kontakt und der Kontaktbahn zu befürchten sind.

### Zeichnung

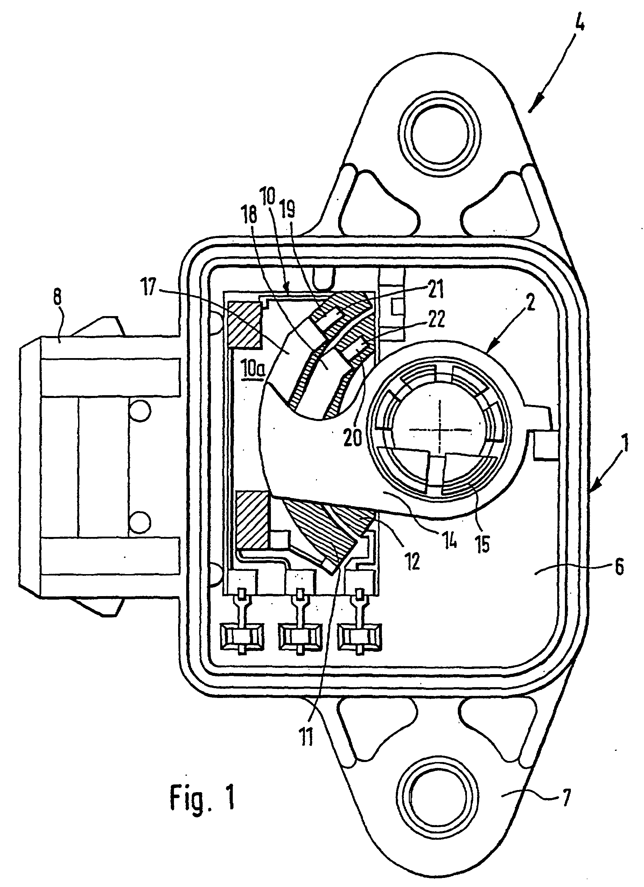

Bevorzugt ausgewählte, besonders vorteilhafte Ausführungsbeispiele der Erfindung sind in der Zeichnung vereinfacht dargestellt und in der nachfolgenden Beschreibung näher erläutert. Es zeigen die Figuren 1 bis 9 verschiedene Einzelheiten und Ansichten beispielhaft ausgewählter unterschiedlich ausgeführter, besonders vorteilhafter Ausführungsformen des Positionssensors.

### Beschreibung der Ausführungsbeispiele

Der erfindungsgemäß ausgeführte Positionssensor ist vorzugsweise für Kraftfahrzeuge vorgesehen, wenn eine Position eines gegenüber einem anderen Bauteil bewegbaren Bauteils erfaßt werden soll. Insbesondere ist der Positionssensor besonders gut geeignet, wenn die beiden Bauteile gegeneinander schwenkbar bzw. drehbar gelagert sind. Ganz besonders geeignet ist der Positionssensor, um die Winkellage einer schwenkbar bzw. drehbar gelagerten Drosselklappe gegenüber einem Drosselklappenstutzen bzw. einem Gaskanal zu ermitteln.

Die **Figur 1** zeigt beispielhaft ein erstes bevorzugt ausgewähltes Ausführungsbeispiel eines erfindungsgemäß ausgeführten Positionssensors 4. Der Positionssensor 4 besteht im wesentlichen aus einem ersten Sensorteil 1 und einem zweiten Sensorteil 2.

Das erste Sensorteil 1 umfaßt im wesentlichen ein Gehäuse 6 mit angeformten Befestigungslaschen 7 und mit einer angeformten Steckkupplung 8, sowie einen Kontaktbahnträger 10. Das Gehäuse 6 umschließt einen Hohlraum, in dem der Kontaktbahnträger 10 befestigt ist. Der Hohlraum des Gehäuses 6 kann mit Hilfe eines Deckels verschlossen werden. Der Positionssensor 4 ist jedoch ohne diesen Deckel dargestellt, damit ein Blick in den Hohlraum bzw. Innenraum des Gehäuses 6 möglich ist.

Der Kontaktbahnträger 10 umfaßt ein als Basisplatte dienendes Trägermaterial 10a. Auf dem Trägermaterial 10a sind eine elektrische Kontaktbahn 11 und eine elektrische Kontaktbahn 12 aufgetragen bzw. aufgedruckt. Die Kontaktbahnen 11 und 12 können als zum ersten Sensorteil 1 gehörend betrachtet werden. Die Kontaktbahnen 11 und 12 können beispielsweise auch direkt auf eine ebene Fläche des Gehäuses 6 aufgedruckt sein, was bedeutet, daß bei dieser Variante das Trägermaterial 10a verzichtbar ist.

Das zweite Sensorteil 2 umfaßt im wesentlichen einen gegenüber dem ersten Sensorteil 1 drehbar gelagerten Träger 14. Am Träger 14 gibt es eine Mitnahme 15. Über die Mitnahme 15 kann ein Bauteil, dessen Position gegenüber einem mit dem ersten Sensorteil 1 verbundenen anderen Bauteil erfaßt werden soll, drehfest verbunden sein.

Am Träger 14 sind ein federndes erstes Schleiferplättchen 17 und ein federndes zweites Schleiferplättchen 18 befestigt. Das Schleiferplättchen 17 trägt einen Schleifer oder eine federnde Kontaktbürste 19. Das Schleiferplättchen 18 trägt ebenfalls einen Schleifer oder eine federnde Kontaktbürste 20. An dem dem Träger 14 abgewandten Ende der Kontaktbürste 19 ist ein elektrischer Kontakt 21 vorgesehen. An dem dem Träger 14 abgewandten Ende der Kontaktbürste 20 gibt es einen elektrischen Kontakt 22. Der verschiebbare bzw. verdrehbare Träger 14 wird axial gehalten, ist gegen Kippen gesichert und drückt über die Schleiferplättchen 17 bzw. 18 und über die Kontaktbürsten 19 bzw. 20 den elektrischen Kontakt 21 federnd gegen die Kontaktbahn 11 und den elektrischen Kontakt 22 federnd gegen die elektrische Kontaktbahn 12. Die beiden elektrischen Kontakte 21, 22 sind über die Kontaktbürsten 19, 20 und die Schleiferplättchen 17, 18 elektrisch miteinander verbunden.

Der Träger 14 ist um eine in der Mitte der Mitnahme 15 vorgesehene Achse drehbar gelagert. Bei Drehung des Trägers 14 um die Achse werden die Kontaktbürsten 19, 20 über die Kontaktbahnen 11, 12 bewegt. Dabei kontaktiert der elektrische Kontakt 21 die Kontaktbahn 11 je nach Drehstellung des Trägers 14 an unterschiedlichen Positionen. Entsprechend bewegt sich der elektrische Kontakt 22, abhängig von der jeweiligen Drehung des Trägers 14, entlang der Kontaktbahn 12.

Bei dem in der Figur 1 gezeigten Beispiel ist das erste Sensorteil 1 beispielsweise mit durch die Befestigungslaschen 7 durchragenden Schrauben an einen, der besseren Übersichtlichkeit wegen, in der Figur 1 nicht dargestellten Drosselklappenstutzen fest angeschraubt, und das zweite Sensorteil 2 ist beispielsweise über die Mitnahme 15 mit einer drehbar gelagerten, der besseren Übersichtlichkeit wegen, in der Figur 1 ebenfalls nicht dargestellten Drosselklappe drehfest verbunden.

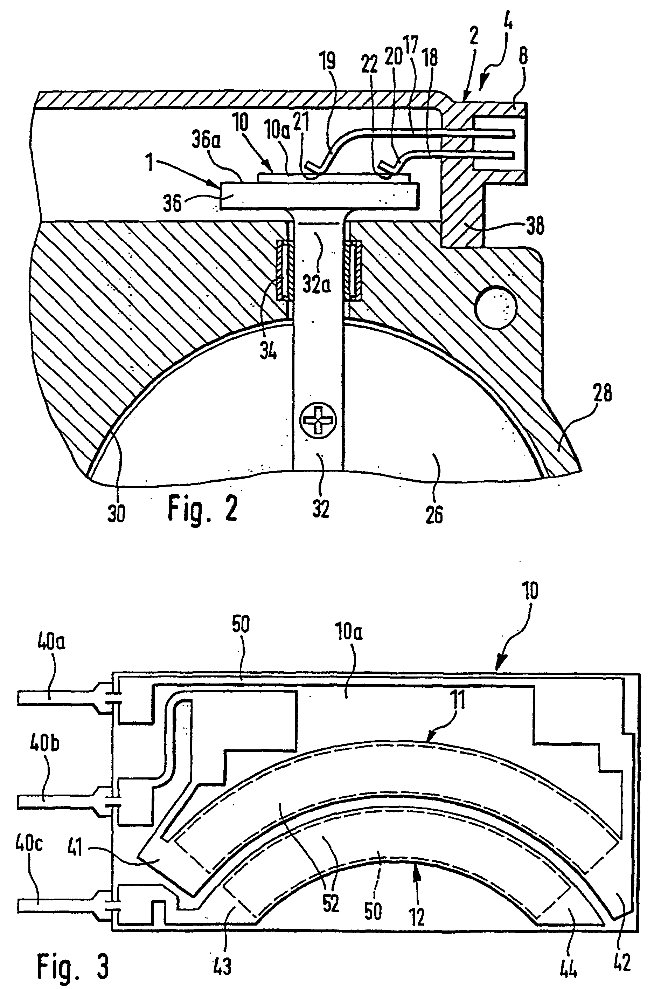

Die **Figur 2** zeigt beispielhaft einen abgewandelt ausgeführten Positionssensor 4.

In allen Figuren sind gleiche oder gleichwirkende Teile mit denselben Bezugszeichen versehen. Sofern nichts Gegenteiliges erwähnt bzw. in der Zeichnung dargestellt ist, gilt das anhand eines der Figuren Erwähnte und Dargestellte auch bei den anderen Ausführungsbeispielen. Sofern sich aus den Erläuterungen nichts anderes ergibt, sind die Einzelheiten der verschiedenen Ausführungsbeispiele miteinander kombinierbar.

Der Positionssensor 4 kann, wie die Figur 1 zeigt, so ausgebildet sein, daß das die Kontaktbahnen 11 und 12 umfassende erste Sensorteil 1 beispielsweise fest an ein eine feststehende Basis bildendes Bauteil montiert ist, und das die Kontakte 21 und 22 umfassende zweite Sensorteil 2 ist mit einem zweiten Bauteil bewegungsmäßig gekoppelt, wobei das zweite Bauteil gegenüber dem ersten Bauteil drehbar gelagert ist. Umgekehrt kann der Positionssensor 4 aber auch, wie die Figur 2 zeigt, so ausgebildet sein, daß das die Kontakte 21 und 22 umfassende zweite Sensorteil 2 fest mit einem eine Basis bildenden Bauteil verbunden ist und das die Kontaktbahnen 11 und 12 umfassende erste Sensorteil 1 ist bewegungsmäßig an ein anderes Bauteil gekoppelt, wobei das andere Bauteil gegenüber dem die Basis bildenden ersten Bauteil bewegbar bzw. schwenk- oder drehbar gelagert ist.

Die Figur 2 zeigt ein bevorzugt ausgewähltes Ausführungsbeispiel, bei dem der Positionssensor 4 so gestaltet ist, daß er zum Erfassen des Schwenkwinkels einer Drosselklappe 26 besonders gut angepaßt ist. Bei dem in der Figur 2 dargestellten Ausführungsbeispiel gibt es einen Drosselklappenstutzen 28. Durch den Drosselklappenstutzen 28 verläuft ein Gaskanal 30. Der Gaskanal 30 führt beispielsweise von einem nicht dargestellten Luftfilter zu einem nicht dargestellten Brennraum oder zu mehreren Brennräumen einer nicht dargestellten Brennkraftmaschine eines Kraftfahrzeugs. Der in der Figur 2 wiedergegebene Schnitt verläuft quer durch den Gaskanal 30. Durch den Gaskanal 30 kann Luft oder ein Kraftstoff-Luft-Gemisch strömen. Quer durch den Gaskanal 30 erstreckt sich eine Drosselklappenwelle 32. Die Drosselklappenwelle 32 hat ein oberes Ende 32a und ein nicht dargestelltes, unteres Ende. Die Drosselklappenwelle 32 ist im Bereich des Endes 32a mit Hilfe eines Lagers 34 im Drosselklappenstutzen 28 drehbar gelagert. Die Drosselklappe 26 ist mit einer Befestigungsschraube an der Drosselklappenwelle 32 befestigt. Die Drosselklappenwelle 32 kann zwischen zwei Endstellungen um beispielsweise ca. 90° geschwenkt werden. In einer der beiden Endstellungen verschließt die Drosselklappe 26 den Gaskanal 30 nahezu vollständig. In der anderen Endstellung des Schwenkbereichs der Drosselklappenwelle 32 ist der Gaskanal 30 maximal geöffnet.

In der Zeichnung sind verschiedene Bereiche des Drosselklappenstutzens 28, des Gaskanals 30, der Drosselklappenwelle 32 und der Drosselklappe 26 nicht dargestellt, damit andere Bereiche bei nicht zu großem Platzbedarf möglichst groß gezeigt werden können.

Außerhalb des Gaskanals 30 ist am Ende 32a der Drosselklappenwelle 32 ein Drehteil 36 drehfest mit der Drosselklappenwelle 32 verbunden. An dem Drosselklappenstutzen 28 ist ein Gehäuse 38 befestigt. Die mechanische Verbindung zwischen dem Drosselklappenstutzen 28 und dem Gehäuse 38 ist so ausgeführt, daß im montierten Zustand keine Relativbewegung zwischen dem Gehäuse 38 und dem Drosselklappenstutzen 28 stattfinden kann.

Das Drehteil 36 hat eine stirnseitige, dem Drosselklappenstutzen 28 und der Drosselklappe 26 abgewandte ebene Fläche 36a. An der Fläche 36a ist der Kontaktbahnträger 10 befestigt. An dem Kontaktbahnträger 10 befinden sich die Kontaktbahnen 11 und 12. Die Kontaktbahnen 11, 12 sind so dünn, daß sie bei dem für die Figur 2 gewählten Abbildungsmaßstab mit der gewählten Blickrichtung nicht sichtbar sind. Es sei erwähnt, daß, je nach elektrischer Auswerteschaltung zum Auswerten des von dem Positionssensor 4 gelieferten elektrischen Signals, der Positionssensor 4 eine Kontaktbahn, zwei Kontaktbahnen, drei Kontaktbahnen oder mehr als drei Kontaktbahnen und eine entsprechende Anzahl die Kontaktbahnen kontaktierender elektrischer Kontakte hat.

Die ein, zwei, drei oder mehr Kontaktbahnen 11, 12 befinden sich auf dem Kontaktbahnträger 10 und sind über den Kontaktbahnträger 10 bewegungsmäßig an die Drosselklappenwelle 32 gekoppelt. Die Kontaktbahnen 11, 12 können aber auch direkt auf der Fläche 36a des Drehteils 36 aufgetragen sein, was bedeutet, daß das Trägermaterial 10a bei dieser Ausführungsvariante entfällt.

Bei dem in der Figur 2 dargestellten Ausführungsbeispiel umfaßt das erste Sensorteil 1 im wesentlichen den drehbar gelagerten Kontaktbahnträger 10 mit den auf dem Kontaktbahnträger 10 aufgetragenen Kontaktbahnen 11 und 12, und das gegenüber dem Drosselklappenstutzen 28 stationär angebrachte zweite Sensorteil 2 umfaßt im wesentlichen die die Kontaktbahnen 11, 12 elektrisch kontaktierenden elektrischen Kontakte 21 und 22.

In der **Figur 3** ist der beispielsweise im Gehäuse 6 (Fig. 1) angebrachte Kontaktbahnträger 10 mit geändertem Maßstab separat wiedergegeben. Die Figur 3 zeigt eine Draufsicht auf eine Seite des Kontaktbahnträgers 10, auf der die Kontaktbahnen 11 und 12 aufgetragen sind. Aus Platzgründen ist der Kontaktbahnträger 10 in der Figur 3 gegenüber der Figur 1 um 90° gedreht dargestellt.

An dem Trägermaterial 10a des Kontaktbahnträgers 10 gibt es eine Kontaktlasche 40a, eine Kontaktlasche 40b und eine Kontaktlasche 40c. Die erste Kontaktbahn 11 hat ein erstes Ende 41 und ein zweites Ende 42. Die zweite Kontaktbahn 12 hat ein erstes Ende 43 und ein zweites Ende 44. Das erste Ende 41 der Kontaktbahn 11 ist elektrisch mit der Kontaktlasche 40b verbunden. Das zweite Ende 42 ist elektrisch mit der Kontaktlasche 40a verbunden, und das Ende 43 der Kontaktbahn 12 ist elektrisch mit der Kontaktlasche 40c verbunden. Diese elektrischen Verbindungen zwischen den Kontaktbahnen 11, 12 und den Kontaktlaschen 40a, 40b, 40c entstehen durch auf das Trägermaterial 10a mit entsprechender Kontur aufgedrucktes elektrisch leitfähiges Material 50. Die Kontaktlaschen 40a, 40b, 40c sind mit in der Steckkupplung 8 (Fig. 1) vorgesehenen Kontaktstiften elektrisch verbunden. Über das elektrisch leitfähige Material 50 wird in einem weiteren Arbeitsgang ein Widerstandsmaterial 52 aufgedruckt. Im Bereich zwischen den Enden 41 und 42 der Kontaktbahn 11 sowie im Bereich der zwischen den Enden 41 bzw. 42 und den Kontaktlaschen 40a bzw. 40b vorgesehenen festen elektrischen Widerstände ist das elektrisch leitfähige Material 50 unterbrochen, so daß die festen Widerstände mit genau festlegbaren Widerstandswerten entstehen. Das Widerstandsmaterial 52 ist im wesentlichen nur in den Bereichen der festen Widerstände und der Kontaktbahnen 11 und 12 aufgetragen. Im Bereich der Kontaktbahn 12 erstreckt sich das elektrisch leitfähige Material 50 unterhalb des Widerstandsmaterials 52 durchgehend zwischen den Enden 43 und 44.

Für eine einwandfreie Funktion des Positionssensors 4 hat der auf der Kontaktbahn 11 gleitende elektrische Kontakt 21 etwas Abstand zu den seitlichen Rändern der Kontaktbahn 11. Der Kontakt 21 kann entlang der Kontaktbahn 11 bewegt werden, bis er nicht ganz die Enden 41 bzw. 42 erreicht. Deshalb ist der nutzbare Bereich der Kontaktbahn 11 etwas kleiner als die Fläche des aufgedruckten Widerstandsmaterials 52. Der nutzbare Bereich der Kontaktbahn 11 ist in der Figur 3 durch einen mit gestrichelten Linien angedeuteten Rahmen schematisch dargestellt.

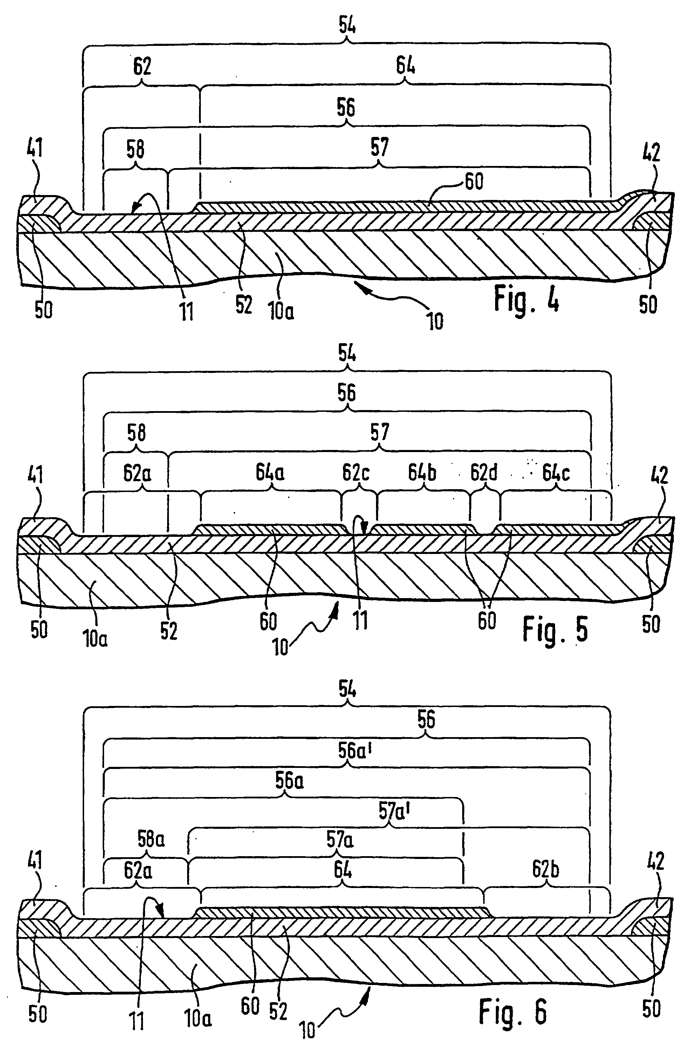

Nachfolgend wird der nutzbare Bereich der Kontaktbahn 11 näher betrachtet. Dazu ist in der Figur 4 ein in der Mitte der Kontaktbahn 11 verlaufender Längsschnitt wiedergegeben.

Die Schnittfläche des Längsschnitts ist entsprechend der Krümmung der Kontaktbahn 11 ebenfalls gekrümmt, jedoch in der Figur 4 als ebene Fläche wiedergegeben.

Die **Figur 4** zeigt beispielhaft einen Längsschnitt des Kontaktbahnträgers 10 entlang der Kontaktbahn 11.

Weil die auf dem Trägermaterial 10a aufgetragenen Schichten real ziemlich dünn sind, sind in den Figuren 4 bis 9 die aufgetragenen Schichten quer zur Oberfläche sehr viel stärker vergrößert dargestellt als in Längsrichtung der Oberfläche, um in der Zeichnung sichtbar zu sein.

Die für die Kontaktierung des Kontakts 21 nutzbare Länge der Kontaktbahn 11 zwischen den beiden Enden 41 und 42 wird nachfolgend als nutzbare Kontaktbahnlänge 54 bezeichnet. Damit der Kontakt 21 die nutzbare Kontaktbahnlänge 54 nicht überschreitet, ist der von dem Kontakt 21 tatsächlich überstrichene genutzte Bereich kürzer als die nutzbare Kontaktbahnlänge 54. Der vom Kontakt 21 genutzte Bereich wird nachfolgend als Nutzlänge 56 bezeichnet. Innerhalb der Nutzlänge 56 der Kontaktbahn 11 gibt es einen Längenbereich, der nachfolgend als Ruhezone 58 bezeichnet wird. Die Ruhezone 58 ist der Bereich der Kontaktbahn 11, den der elektrische Kontakt 21 kontaktiert, wenn sich die beiden gegeneinander bewegbar gelagerten Sensorteile 1 und 2 in einer Ruheposition befinden. Wie bereits erläutert, dient der Positionssensor 4 beispielsweise bei einem Kraftfahrzeug zum Sensieren der Stellung der Drosselklappe gegenüber dem Drosselklappenstutzen. Wenn das Kraftfahrzeug abgestellt ist, dann befinden sich die beiden Sensorteile 1 und 2 in der Ruheposition, und der elektrische Kontakt 21 kontaktiert die Kontaktbahn 11 innerhalb der Ruhezone 58. Der nicht zu der Ruhezone 58 gehörende Teil der Nutzlänge 56 wird nachfolgend als Arbeitszone 57 bezeichnet.

Ein Teil der Kontaktbahnlänge 54 ist mit einer Schutzschicht 60 beschichtet. Der Bereich der Kontaktbahnlänge 54, der nicht von der Schutzschicht 60 überzogen ist, wird nachfolgend als ausgesparte Bahnlänge 62 bezeichnet. Der mit der Schutzschicht 60 beschichtete Bereich der Kontaktbahnlänge 54 erhält nachfolgend die Bezeichnung beschichtete Bahnlänge 64. Außerhalb der nutzbaren Kontaktbahnlänge 54 kann der Kontaktbahnträger 10 ebenfalls mit der Schutzschicht 60 beschichtet sein.

Die ausgesparte Bahnlänge 62 ist so dimensioniert, daß sich die Ruhezone 58 innerhalb der ausgesparten Bahnlänge 62 befindet.

Die Figur 5 zeigt in beispielhafter Form eine gegenüber dem in der Figur 4 gezeigten Ausführungsbeispiel abgewandelte Kontaktbahn 11.

Wie die Figur 5 zeigt, ist die Schutzschicht 60 an mehreren Stellen unterbrochen. Die Länge der Schutzschicht 60 unterteilt sich in eine erste beschichtete Bahnlänge 64a, in eine zweite beschichtete Bahnlänge 64b und in eine dritte beschichtete Bahnlänge 64c. Links von der beschichteten Bahnlänge 64a und zwischen den beschichteten Bahnlängen 64a, 64b und 64c befinden sich Bereiche, die nicht mit der Schutzschicht 60 beschichtet sind. Diese Bereiche werden nachfolgend als ausgesparte Bahnlängen 62a, 62c und 62d bezeichnet.

Die Ruhezone 58 befindet sich innerhalb der ausgesparten Bahnlänge 62a.

Die **Figur 6** zeigt ein Ausführungsbeispiel mit einer Abwandlung der Kontaktbahn 11 des Kontaktbahnträgers 10.

Die **Figur 7** zeigt ein Ausführungsbeispiel bei dem die Kontaktbahn 11 des Kontaktbahnträgers 10 gleich gebaut ist wie bei dem in der Figur 6 dargestellten Ausführungsbeispiel. Die Figur 7 unterscheidet sich von der Figur 6 dadurch, daß das in der Figur 7 dargestellte Ausführungsbeispiel eine Ruhezone 58b hat, die an einer anderen Stelle als die Ruhezone 58a in der Figur 6 ist.

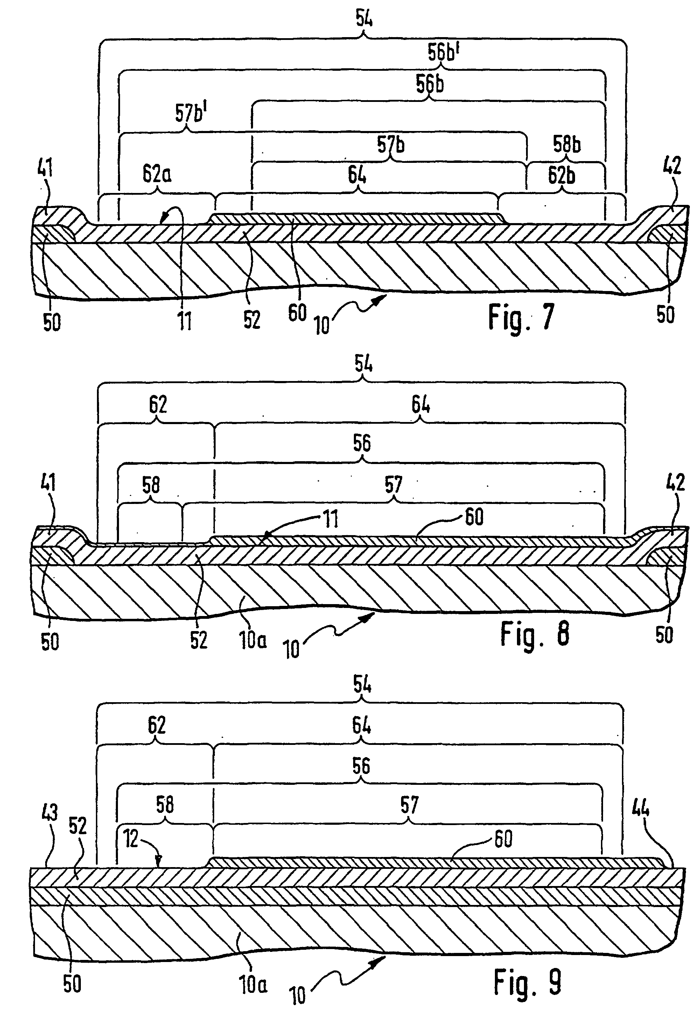

Bei den in den Figuren 6 und 7 gezeigten Ausführungsbeispielen ist die Schutzschicht 60 so aufgetragen, daß die Schutzschicht 60 nicht bis in den Bereich der Enden 41 und 42 reicht. Links von der Schutzschicht 60 befindet sich die ausgesparte Bahnlänge 62a, und rechts von der Schutzschicht 60 gibt es einen nicht überzogenen Bereich, der nachfolgend als ausgesparte Bahnlänge 62b bezeichnet wird. Die beiden ausgesparten Bahnlängen 62a und 62b sind im wesentlichen gleich lang.

Bei dem in der Figur 6 dargestellten Ausführungsbeispiel ist die Ruhezone 58a im Bereich der ausgesparten Bahnlänge 62a vorgesehen. Das in der Figur 7 gezeigte Ausführungsbeispiel hat im Bereich der ausgesparten Bahnlänge 62b eine Ruhezone 58b. Anschließend an die Ruhezone 58a (Fig. 6) bzw. 58b (Fig. 7) beginnt die Arbeitszone 57a (Fig. 6) bzw. 57b (Fig. 7). Die Arbeitszone 57a bzw. 57b erstreckt sich im wesentlichen im Bereich der beschichteten Bahnlänge 64. Der Positionssensor 4 kann jedoch auch so ausgeführt sein, daß sich die Arbeitszone, ausgehend von der Ruhezone 58a bzw. 58b, über die beschichtete Bahnlänge 64 hinaus in die gegenüberliegende ausgesparte Bahnlänge 62a bzw. 62b erstreckt. Die längere Arbeitszone dieser Ausführungsvariante ist mit dem Bezugszeichen 57a' (Fig. 6) bzw. 57b' (Fig. 7) versehen.

Beim Positionssensor 4 nach Figur 6 steht der Kontakt 21 beim Leerlauf der Brennkraftmaschine näher zum ersten Ende 41, und bei Vollast steht der Kontakt 21 näher zum zweiten Ende 42. Beim Positionssensor 4 nach Figur 7 ist es umgekehrt.

Je nachdem an welchem Ende der die Drosselklappe tragenden Drosselklappenwelle der Positionssensor 4 angebracht ist, befindet sich die Ruhezone 58a im Bereich des ersten Endes 41 (Fig. 6) bzw. es befindet sich die Ruhezone 58b im Bereich des'zweiten Endes 42 (Fig. 7). Wie der Vergleich der Figuren 6 und 7 zeigt, ist der Kontaktbahnträger 10 in beiden Fällen gleich ausgeführt, so daß der identisch ausgeführte Positionssensor 4 sowohl für eine von der Ruhezone 58a nach rechts drehende Meßanordnung (Fig. 6) als auch für eine von der Ruhezone 58b nach links drehende Meßanordnung (Fig. 7) verwendet werden kann. Dies erspart die Herstellung unterschiedlicher Positionssensoren.

Die **Figur 8** zeigt ein weiteres, besonders ausgewähltes Ausführungsbeispiel.

Bei dem in der Figur 4 gezeigten Ausführungsbeispiel ist im Bereich der ausgesparten Bahnlänge 62 keine Schutzschicht 60 vorgesehen. Bei dem in der Figur 8 ansonsten gleich gestalteten Ausführungsbeispiel erstreckt sich die Schutzschicht 60 über die gesamte Länge der Kontaktbahn 11. In einem (linken) Bereich der Kontaktbahn 11 ist die Schutzschicht 60 deutlich dünner als in einem anderen (rechten) Bereich der Kontaktbahn 11. Der Bereich der Kontaktbahn 11, in dem die Schutzschicht 60 deutlich dünner ist als in dem anderen Bereich der Kontaktbahn 11, wird nachfolgend der Übersichtlichkeit wegen entsprechend dem in der Figur 4 gezeigten Ausführungsbeispiel ebenfalls als "ausgesparte Bahnlänge 62" bezeichnet. Der Bereich der Kontaktbahn 11, in dem die Schutzschicht 60 deutlich dicker ist als in dem anderen Bereich der Kontaktbahn 11, wird nachfolgend auch der Übersichtlichkeit wegen entsprechend dem in der Figur 4 gezeigten Ausführungsbeispiel ebenfalls als "beschichtete Bahnlänge 64" bezeichnet. Mit anderen Worten, die Schutzschicht 60 hat eine Auftragschichtdicke, die im Bereich der beschichteten Bahnlänge 64 wesentlich dicker ist als die Auftragschichtdicke der Schutzschicht 60 im Bereich der sogenannten ausgesparten Bahnlänge 62. Bei dem in der Figur 8 dargestellten Ausführungsbeispiel ist die Auftragschichtdicke der Schutzschicht 60 im Bereich der sogenannten ausgesparten Bahnlänge 62 gegenüber der Auftragschichtdicke der Schutzschicht 60 im Bereich der sogenannten beschichteten Bahnlänge 64 deutlich merkbar reduziert. Bei dem in der Figur 4 dargestellten Ausführungsbeispiel ist die Auftragschichtdicke der Schutzschicht 60 im Bereich der ausgesparten Bahnlänge 62 nicht nur etwas, sondern vollständig bis auf. Null reduziert.

Das Trägermaterial 10a ist relativ dick. Die Dicke des Trägermaterials 10 beträgt beispielsweise ein Millimeter (0,001 m). Das elektrisch leitfähige Material 50 und das Widerstandsmaterial 52 sind auf dem Trägermaterial 10a aufgetragen, wobei die Dicke des elektrisch leitfähigen Materials 50 und die Dicke des Widerstandsmaterials 52 deutlich kleiner ist als die Dicke des Trägermaterials 10a. Das elektrisch leitfähige Material 50 und das Widerstandsmaterial 52 sind beispielsweise je zehn Mikrometer (10 µm = 0,00001 m) dick. Die Schutzschicht 60 ist im Bereich der beschichteten Bahnlänge 64, 64a, 64b, 64c mit einer Auftragschichtdicke von insbesondere etwa sechs Mikrometer (6 µm = 0,000006 m) aufgetragen. Die Auftragschichtdicke im Bereich der sogenannten beschichteten Bahnlänge 64, 64a, 64b, 64c kann auch vorzugsweise zwischen fünf bis sieben Mikrometer (5 µm - 7 µm) betragen.

Insbesondere auch abhängig von der gewählten Konsistenz der Schutzschicht 60 kann es zweckmäßig sein, die Schutzschicht 60 im Bereich der beschichteten Bahnlänge 64, 64a, 64b bzw. 64c beispielsweise mit einer Auftragschichtdicke von 3 µm oder auch 15 µm oder einem dazwischenliegenden Wert aufzutragen. Im Bereich der sogenannten ausgesparten Bahnlänge 62, 62a, 62b, 62c, 62d ist die Schutzschicht 60 teilweise wesentlich aber nicht ganz reduziert aufgetragen, wie in der Figur 8 dargestellt, bzw. entfällt vollständig, wie beispielsweise in der Figur 4 gezeigt.

Die Schutzschicht 60 wird auf das Trägermaterial 10a aufgedruckt. An den vorgesehenen Stellen überdeckt die aufgedruckte bzw. aufgetragene Schutzschicht 60 das Widerstandsmaterial 52. Dadurch daß die Schutzschicht 60 auf die Kontaktbahn 11 bzw. auf das Trägermaterial 10a aufgedruckt werden kann, ist es leicht möglich, dem Umriß bzw. den Umrissen der Schutzschicht 60 jede beliebige, gewünschte Form zu geben. Je nach durchgeführtem Aufwand beim Aufdrucken der Schutzschicht 60 bzw. je nach Zustand der für das Aufdrucken der Schutzschicht 60 verwendeten Maschinen und Vorrichtungen, befindet sich in der ausgesparten Bahnlänge 62, 62a, 62b, 62c, 62d nichts von der Schutzschicht (Fig. 4), oder es kann auch in den Bereich der sogenannten ausgesparten Bahnlänge etwas von der Schutzschicht 60 hingelangen (Fig. 8) oder bewußt zugelassen sein. Solange die Dicke der Schutzschicht 60 im Bereich der sogenannten ausgesparten Bahnlänge 62 gegenüber der Auftragschichtdicke der Schutzschicht 60 im Bereich der sogenannten beschichteten Bahnlänge 64 merkbar kleiner ist, wird durch die geringere Dicke der Schutzschicht 60 im Bereich der ausgesparten Bahnlänge 62 die Funktion des Positionssensors 4 dadurch nicht beeinträchtigt. Auch bei nicht ganz auf Null reduzierter Auftragschichtdicke der Schutzschicht 60 im Bereich der sogenannten ausgesparten Bahnlänge 62 erhält man durch die Erfindung die eingangs genannten Vorteile. Entsprechendes gilt auch, wenn bei den Figuren 5, 6, 7 und 9 die Auftragschichtdicke der Schutzschicht 60 im Bereich der sogenannten ausgesparten Bahnlängen 62, 62a, 62b, 62c und 62d nicht ganz auf Null reduziert ist.

Ist die Brennkraftmaschine in Betrieb, dann bewegt sich der Kontakt 21 (Fig. 1, 2) im Bereich der Arbeitszone 57 (z. B. Fig. 4) über die Kontaktbahn 11. Wie die Figur 4 zeigt, ist der überwiegende Teil der Arbeitszone 57 mit der Schutzschicht 60 beschichtet. Die Arbeitszone 57 ragt in Bewegungsrichtung nur etwas über die Schutzschicht 60 hinaus. Die Schutzschicht 60 besteht aus einem steifen Fluid bzw. einem pastenartigen Material. Das Material der Schutzschicht 60 ist im wesentlichen elektrisch nicht leitend. Die Schutzschicht 60 besteht vorzugsweise aus einem Fett, einem fettartigen Material, einem dickflüssigen bzw. pastösen Öl oder aus einem ölartigen Material. Die Schutzschicht 60 ist bereits durch eine relativ kleine Kraft, mit der der Kontakt 21 üblicherweise gegen die Kontaktbahn 11 vorgespannt ist, verformbar bzw. bis auf höchstens einen die elektrische Verbindung zwischen dem Kontakt 21 und der Kontaktbahn 11 nicht störenden kleinen Rest aus dem momentanen unmittelbaren Kontaktbereich verdrängbar. Dadurch ist es möglich, daß auch im Bereich der Schutzschicht 60 der Kontakt 21 mit der Kontaktbahn 11 in elektrisch leitender Verbindung steht, obwohl die Schutzschicht 60 im wesentlichen nicht leitend ist. Die Kraft, die den Kontakt 21 gegen die Kontaktbahn 11 spannt, verdrängt im Bereich des Kontakts 21 die Schutzschicht 60 zur Seite, mindestens bis der Kontakt 21 in gute elektrische Verbindung mit der Kontaktbahn 11 gelangt. Wird der Kontakt 21 entlang der Kontaktbahn 11 verschoben, dann wird bewegungsmäßig vor dem Kontakt 21 die Schutzschicht 60 durch den Kontakt 21 verdrängt und hinter dem Kontakt 21 zieht sich die Schutzschicht 60 wieder so weit zusammen, daß die Schutzschicht 60 auch hinter dem Kontakt 21 als im wesentlichen geschlossene Schicht die Kontaktbahn 11 bedeckt. Auch wenn im Bereich der beschichteten Bahnlänge 64 zwischen dem elektrischen Kontakt 21 und der Kontaktbahn 11 eventuell kleinste Partikel der Schutzschicht 60 durch die den Kontakt 21 gegen die Kontaktbahn 11 spannende Kraft nicht verdrängt werden, so sorgt die Schutzschicht 60 trotzdem für eine deutliche Verbesserung der elektrischen Verbindung zwischen dem Kontakt 21 und der Kontaktbahn 11. Insbesondere auch bei längerer Benutzungsdauer des Positionssensors 4 bleibt durch die Schutzschicht 60 die elektrische Verbindung zwischen dem Kontakt 21 und der Kontaktbahn 11 ungestört erhalten. Die Schutzschicht 60 vermindert insbesondere den Verschleiß an der Oberfläche der Kontaktbahn 11 und gegebenenfalls auch den Verschleiß des Kontakts 21, was die mögliche Benutzungsdauer des Positionssensors 4 wesentlich verlängert. Insbesondere wegen dem Abrieb, der durch die Schutzschicht 60 verhindert oder zumindest deutlich reduziert wird, würde ohne die Schutzschicht 60 die elektrische Verbindung zwischen dem elektrischen Kontakt 21 und der Kontaktbahn 11 bei längerer Benutzungsdauer des Positionssensors 4 beeinträchtigt.

Wie die Figuren 4 bis 7 zeigen, muß nicht in der gesamten Arbeitszone 57, 57a, 57a', 57b, 57b' die Schutzschicht 60 aufgetragen sein. Auch wenn die Schutzschicht 60 nicht in der gesamten Arbeitszone 57, 57a, 57a', 57b bzw. 57b' aufgetragen ist, wird dadurch die positive Wirkung der Schutzschicht 60 nicht beeinträchtigt, weil, während der Kontakt 21 die Schutzschicht 60 durchfährt, so viel von dem Material aus der Schutzschicht 60 zwischen dem Kontakt 21 und der Kontaktbahn 11 haften bleibt, bzw. der Kontakt 21 von dem Material der Schutzschicht 60 in den Bereich der ausgesparten Bahnlänge 62, 62a, 62b, 62c, 62d mitgeschleppt, daß eine ausreichende Schutzwirkung auch außerhalb der beschichteten Bahnlänge 64, 64a, 64b bzw. 64c gewährleistet ist.

Der Positionssensor 4 kann so ausgelegt sein, daß die Arbeitszone 57a auf dem der Ruhezone 58a abgewandten Ende der Kontaktbahn 11 nicht über die beschichtete Bahnlänge 64 hinausragt (Fig. 6). Der Positionssensor 4 kann aber auch so ausgelegt sein, daß die Arbeitszone 57a' auch auf dem der Ruhezone 58a abgewandten Ende deutlich über die beschichtete Bahnlänge 64 hinausragt (ebenfalls Fig. 6). Dies ist möglich, weil, während der Kontakts 21 auf der Kontaktbahn 11 die Schutzschicht 60 durchfährt, ausreichend viel von dem Material aus der Schutzschicht 60 zwischen dem Kontakt 21 und der Kontaktbahn 11 haften bleibt und in den Bereich außerhalb der beschichteten Bahnlänge 64 verschleppt wird, daß die Schutzschicht 60 auch außerhalb der beschichteten Bahnlänge 64 die vorgesehene Schutzwirkung entfalten kann. Entsprechendes gilt auch für die Figur 7, wo die Arbeitszone 57b ebenfalls im wesentlichen nur innerhalb der beschichteten Bahnlänge 64 vorgesehen sein kann oder wo die Arbeitszone 57b' deutlich über die beschichtete Bahnlänge 64 hinausführen kann.

Wenn die Brennkraftmaschine abgestellt ist, dann befinden sich die beiden Sensorteile 1 und 2 (Fig. 1, 2) gegenseitig in einer derartigen Position, daß der Kontakt 21 die Kontaktbahn 11 innerhalb der Ruhezone 58, 58a bzw. 58b elektrisch kontaktiert. Bei abgestellter Brennkraftmaschine ist die Drosselklappe geschlossen und dabei steht der Kontakt 21 im Bereich der Ruhezone 58, 58a bzw. 58b. Die Brennkraftmaschine kann längere Zeit abgestellt sein, was bedeutet, daß der Kontakt 21 die Kontaktbahn 11 ebenso lange innerhalb der Ruhezone 58, 58a bzw. 58b elektrisch kontaktiert. Weil im Bereich der ausgesparten Bahnlänge 62, 62a, 62b und damit insbesondere im Bereich der Ruhezone 58 (Fig. 4, 5) bzw. im Bereich der Ruhezone 58a (Fig. 6) bzw. im Bereich der Ruhezone 58b (Fig. 7) die Schutzschicht 60 nicht aufgetragen ist bzw. nur extrem dünn, insbesondere deutlich dünner als im Bereich der beschichteten Bahnlänge 64 aufgetragen ist (Fig. 8), kann es zu keiner störenden Beeinflussung der elektrischen Verbindung zwischen der Kontaktbahn 11 und dem elektrischen Kontakt 21 kommen, wenn die Brennkraftmaschine wieder gestartet wird und die beiden Sensorteile 1 und 2 wieder beginnen sich gegeneinander zu verdrehen. Wäre die Schutzschicht 60 auch im Bereich der Ruhezone 58 mit der gleichen Dicke wie in der beschichteten Bahnlänge 64 aufgetragen, dann würde sich die Schutzschicht 60, während die beiden Sensorteile 1 und 2 gegenseitig nicht bewegt werden, durch eventuelle Adhäsion im Bereich um den Kontakt 21 verstärkt ansammeln und es würde, insbesondere wenn der Bewegungsbeginn der beiden Sensorteile 1 und 2 bei besonders tiefen Temperaturen geschieht, wegen eventueller Versteifung des Materials der Schutzschicht 60, zu einer kurzen Unterbrechung der elektrischen Verbindung zwischen dem Kontakt 21 und der Kontaktbahn 11 bzw. zu einer kurzfristigen Verschlechterung der elektrischen Verbindung kommen, was zu einer Funktionsstörung führen würde bzw. zu einer Fehlermeldung einer den Positionssensor 4 elektronisch überwachenden Schaltung. Die Unterbrechung der elektrischen Verbindung könnte eventuell von einem Aufgleiten des Kontakts 21 auf die Schutzschicht 60 herkommen. Wenn die Schutzschicht 60 im Bereich der Ruhezone 58, 58a, 58b nicht mindestens deutlich dünner als im Bereich der beschichteten Bahnlänge 64, 64a, 64b, 64c aufgetragen wäre, dann wäre die Gefahr einer Funktionsstörung besonders groß, wenn die Brennkraftmaschine bei relativ hoher Temperatur abgestellt wird und bei relativ niedriger Temperatur wieder gestartet werden soll. Bei zu dünnem Auftragen der Schutzschicht 60 auch im Bereich der beschichteten Bahnlänge 64, 64a, 64b, 64c ist die Schutzwirkung der Schutzschicht 60 nicht immer voll gewährleistet, und ein zu dünnes Auftragen der Schutzschicht 60 im.Bereich der beschichteten Bahnlänge 64, 64a, 64b, 64c ist bei manchen Fertigungsverfahren etwas problematisch.

Die **Figur 9** zeigt beispielhaft einen Längsschnitt durch die Kontaktbahn 12.

Bei der Kontaktbahn 12 erstreckt sich das elektrisch leitfähige Material 50 über die gesamte Länge der Kontaktbahn 12. Dadurch hat der die Kontaktbahn 12 kontaktierende elektrische Kontakt 22 in Richtung der Kontaktlasche 40c (Fig. 3) unabhängig von seiner Position stets den gleichen elektrischen Anschlußwert.

Auch bei der Kontaktbahn 12 ist ein Teil der Kontaktbahn 12 mit der Schutzschicht 60 geschützt, und auf einem Teil der Kontaktbahnlänge 54 ist die Schutzschicht 60 nicht vorhanden oder zumindest deutlich dünner als im Bereich der beschichteten Bahnlänge 64. Die in der Figur 9 beispielhaft dargestellte Kontaktbahn 12 ist in gleicher Weise mit der Schutzschicht 60 beschichtet wie die in der Figur 4 beispielhaft dargestellte Kontaktbahn 11. Es sei darauf hingewiesen, daß auch die Kontaktbahn 12 in gleicher Weise wie die in den Figuren 5 bis 8 beispielhaft dargestellte, unterschiedlich beschichtete Kontaktbahn 11 mit der Schutzschicht 60 beschichtet sein kann.

Es gibt Brennkraftmaschinen, bei denen im abgestellten Ruhezustand die Drosselklappe in einer Endlage steht. In diesem Fall befindet sich die Ruhezone 58, 58a bzw. 58b im Bereich des Endes 41 bzw. 43 oder im Bereich des Endes 42, wie in den Figuren 4 bis 9 dargestellt. Es gibt aber auch Brennkraftmaschinen, bei denen im abgestellten Ruhezustand die Drosselklappe von einer Feder in einer Zwischenstellung gehalten wird. Für diesen Fall wird vorgeschlagen, die Ruhezone, d. h. die Zone in der die Schutzschicht 60 nicht aufgetragen bzw. mit reduzierter Auftragschichtdicke aufgetragen ist, nicht im Endbereich der Kontaktbahn 11 bzw. 12 vorzusehen, sondern in einem mittleren Bereich der Kontaktbahnlänge 54 und entsprechend links und rechts von der ausgesparten Bahnlänge die Kontaktbahn 11 bzw. 12 mit der Schutzschicht 60 zu beschichten, so daß bei abgestellter Brennkraftmaschine oder ggf. auch wenn die Brennkraftmaschine im Leerlauf arbeitet, der Kontakt 21 bzw. 22 in einem Bereich der Kontaktbahn 11 bzw. 12 steht, in dem die Schutzschicht 60 nicht bzw. deutlich reduziert aufgetragen ist.

## Patentansprüche

1. Positionssensor, insbesondere für ein Kraftfahrzeug, mit einem ersten Sensorteil (1) und einem zweiten Sensorteil (2), zum Erfassen einer veränderbaren Position der beiden gegeneinander bewegbar gelagerten Sensorteile, mit mindestens einer, mit einer der beiden Sensorteile verbundenen elektrischen Kontaktbahn (11, 12) und mit mindestens einem, mit der jeweils anderen der beiden Sensorteile verbundenen, die Kontaktbahn elektrisch kontaktierenden Kontakt (21, 22), wobei die Position der beiden Sensorteile gegeneinander die Stellung des Kontakts gegenüber der Kontaktbahn bestimmt, **dadurch gekennzeichnet, daß** auf die mindestens eine elektrische Kontaktbahn (11, 12) mindestens eine Schutzschicht (60) mit einer Auftragschichtdicke aufgetragen ist, wobei die Auftragschichtdicke der Schutzschicht (60) auf der elektrischen Kontaktbahn (11, 12) an mindestens einer Stelle (62, 62a, 62b, 62c, 62d) mindestens teilweise reduziert ist.

2. Positionssensor nach Anspruch 1, **dadurch gekennzeichnet, daß** die beiden Sensorteile (1, 2) gegeneinander drehbar gelagert sind.

3. Positionssensor nach Anspruch 1 oder 2, **dadurch gekennzeichnet, daß** die Schutzschicht (60) auf der elektrischen Kontaktbahn (11, 12) an der mindestens einen Stelle (62, 62a, 62b, 62c, 62d) nicht aufgetragen ist.

4. Positionssensor nach einem der Ansprüche 1 bis 3, **dadurch gekennzeichnet, daß** es auf der mindestens einen elektrischen Kontaktbahn (11, 12) mindestens eine Ruhezone (58, 58a, 58b) gibt, in der der Kontakt (21, 22) die Kontaktbahn (11, 12) einige Zeit in Ruhe elektrisch kontaktiert, wobei mindestens in der Ruhezone (58, 58a, 58b) die Auftragschichtdicke der Schutzschicht (60) auf der elektrischen Kontaktbahn (11, 12) mindestens teilweise reduziert ist.

5. Positionssensor nach Anspruch 4, **dadurch gekennzeichnet, daß** die Schutzschicht (60) auf der elektrischen Kontaktbahn (11, 12) in der Ruhezone (58, 58a, 58b) nicht aufgetragen ist.

6. Positionssensor nach einem der vorhergehenden Ansprüche, **dadurch gekennzeichnet, daß** die Schutzschicht (60) aus einem fettartigen Material besteht.

7. Positionssensor nach einem der Ansprüche 1 bis 5, **dadurch gekennzeichnet, daß** die Schutzschicht (60) aus einem ölartigen Material besteht.

8. Positionssensor nach einem der vorhergehenden Ansprüche, **dadurch gekennzeichnet, daß** die Schutzschicht (60) aus einem elektrisch nichtleitenden Material besteht.

9. Positionssensor nach einem der vorhergehenden Ansprüche, **dadurch gekennzeichnet, daß** die mindestens eine Kontaktbahn (11, 12) zwei Enden hat und mindestens im Bereich der beiden Enden die Auftragschichtdicke der Schutzschicht (60) auf der elektrischen Kontaktbahn (11, 12) mindestens teilweise reduziert ist.

10. Positionssensor nach Anspruch 9, **dadurch gekennzeichnet, daß** die Schutzschicht (60) auf der elektrischen Kontaktbahn (11, 12) im Bereich der beiden Enden nicht aufgetragen ist.

## Claims

1. Position sensor, in particular for a motor vehicle, having a first sensor part (1) and a second sensor part (2), for detecting a variable position of the two sensor parts which are mounted such that they can move relative to one another, having at least one electrical contact track (11, 12) connected to one of the two sensor parts, and having at least one contact (21, 22) which is connected to the respective other of the two sensor parts and makes electrical contact with the contact track, the position of the two sensor parts relative to one another determining the position of the contact with respect to the contact track, **characterized in that** at least one protective layer (60) having an application layer thickness is applied to the at least one electrical contact track (11, 12), the application layer thickness of the protective layer (60) on the electrical contact track (11,12) being at least partly reduced at at least one location (62, 62a, 62b, 62c, 62d).

2. Position sensor according to Claim 1, **characterized in that** the two sensor parts (1, 2) are mounted such that they can rotate relative to one another.

3. Position sensor according to Claim 1 or 2, **characterized in that** the protective layer (60) is not applied on the electrical contact track (11, 12) at the at least one location (62, 62a, 62b, 62c, 62d).

4. Position sensor according to one of Claims 1 to 3, **characterized in that**, on the at least one electrical contact track (11, 12), there is at least one rest zone (58, 58a, 58b), in which the contact (21, 22) makes electrical contact with the contact track (11, 12) for a time at rest, the application layer thickness of the protective layer (60) on the electrical contact track (11, 12) being at least partly reduced at least in the rest zone (58, 58a, 58b).

5. Position sensor according to Claim 4, **characterized in that** the protective layer (60) is not applied on the electrical contact track (11, 12) in the rest zone (58, 58a, 58b).

6. Position sensor according to one of the preceding claims, **characterized in that** the protective layer (60) is composed of a fatty material.

7. Position sensor according to one of Claims 1 to 5, **characterized in that** the protective layer (60) is composed of an oily material.

8. Position sensor according to one of the preceding claims, **characterized in that** the protective layer (60) is composed of an electrically non-conductively material.

9. Position sensor according to one of the preceding claims, **characterized in that** the at least one contact track (11, 12) has two ends and the application layer thickness of the protective layer (60) on the electrical contact track (11, 12) is at least partly reduced at least in the region of the two ends.

10. Position sensor according to Claim 9, **characterized in that** the protective layer (60) is not applied on the electrical contact track (11, 12) in the region of the two ends.

## Revendications

1. Capteur de position, notamment pour un véhicule automobile, comprenant :
- une première partie de capteur (1) et une seconde partie de capteur (2) pour détecter une position variable des deux parties de capteur mobiles l'une par rapport à l'autre,
- au moins un chemin de contact (11, 12) relié électriquement à l'une des deux parties de capteur et
- au moins un contact (21, 22) relié chaque fois à l'autre partie de capteur et venant en contact électrique avec le chemin de contact,
la position des deux parties de capteur l'une par rapport à l'autre définissant la position du contact par rapport au chemin de contact,
**caractérisé en ce qu'**
au moins l'un des chemins de contact électrique (11, 12) porte au moins une couche protectrice (60) avec une épaisseur de couche au moins en partie réduite à au moins un endroit (62, 62a, 62b, 62c, 62d).

2. Capteur de position selon la revendication 1,
**caractérisé en ce que**
les deux parties de capteur (1, 2) sont montées à rotation l'une par rapport à l'autre.

3. Capteur de position selon l'une quelconque des revendications 1 ou 2,
**caractérisé en ce que**
la couche protectrice (60) sur le chemin de contact électrique (11, 12) n'est pas prévue à au moins un endroit (62, 62a, 62b, 62c, 62d).

4. Capteur de position selon l'une quelconque des revendications 1 à 3,
**caractérisé en ce que**
sur au moins un chemin de contact électrique (11, 12), il est prévu au moins une zone de repos (58, 58a, 58b) dans laquelle le contact (21, 22) touche le chemin de contact (11, 12) pendant un certain temps, électriquement en repos,
et au moins dans la zone de repos (58, 58a, 58b), l'épaisseur d'application de la couche protectrice (60) sur le chemin de contact électrique (11, 12) est au moins en partie réduite.

5. Capteur de position selon la revendication 4,
**caractérisé en ce que**
la couche protectrice (60) sur le chemin de contact électrique (11, 12) n'est pas prévue dans la zone de repos (58, 58a, 58b).

6. Capteur de position selon l'une quelconque des revendications précédentes,
**caractérisé en ce que**
la couche protectrice (60) est réalisée en une matière graisseuse.

7. Capteur de position selon l'une quelconque des revendications 1 à 5,
**caractérisé en ce que**
la couche protectrice (60) est en une matière huileuse.

8. Capteur de position selon l'une quelconque des revendications précédentes,
**caractérisé en ce que**
la couche protectrice (60) est en une matière non conductrice électrique.

9. Capteur de position selon l'une quelconque des revendications précédentes,
**caractérisé en ce qu'**
au moins un chemin de contact (11, 12) possède deux extrémités et qu'au moins dans la zone des deux extrémités, l'épaisseur de la couche protectrice (60) réalisée sur le chemin de contact électrique (11, 12) est au moins en partie réduite.

10. Capteur de position selon la revendication 9,
**caractérisé en ce que**
la couche protectrice (60) n'est pas appliquée sur le chemin de contact électrique (11, 12) dans la zone des deux extrémités.
